# FASCICULE DE BREVET EUROPEEN

(11) **EP 3 738 066 B1**
(45) Date de publication et mention de la délivrance du brevet: **27.12.2023**
(21) Numéro de dépôt: 19700241.3
(22) Date de dépôt: 11.01.2019
(51) Int. Cl.: G06K 7/08, G01R 33/09

(54) **LECTEUR DE CARTE MAGNETIQUE A CAPTEUR A MAGNETORESISTANCE A EFFET TUNNEL**
MAGNETKARTENLESER MIT TUNNELMAGNETWIDERSTANDSSENSOR
MAGNETIC CARD READER WITH TUNNEL MAGNETORESISTANCE SENSOR

(30) Priorité: 12.01.2018 FR 1850279
(43) Date de publication de la demande: 18.11.2020
(73) Titulaire: Banks and Acquirers International Holding, 75015 Paris (FR)
(72) Inventeur: SOUBIRANE, Alain, 26500 BOURG-LES-VALENCES (FR); CARABELLI, Andre, 07130 SAINT-PERAY (FR); MARSAUD, Thierry, 33400 TALENCE (FR); COUSSIEU, Alain, 07000 FLAVIAC (FR); PAVAGEAU, Stephane, 26600 LA ROCHE DE GLUN (FR)
(74) Mandataire: LLR
(86) Numéro de dépôt international: PCT/EP2019/050714
(87) Numéro de publication internationale: WO 2019/138085

(56) Documents cités:
- CN-A- 103 576 101
- JP-A- 2015 200 551
- US-A1- 2011 278 359
- US-A1- 2015 097 033

## Description

### 1. Domaine

La présente invention se rapporte au domaine de la lecture de cartes magnétiques. Elle a plus particulièrement pour objet un lecteur de carte magnétique qui comprend un capteur à magnétorésistance à effet tunnel. Un tel lecteur de carte magnétique offre des avantages en termes de compacité et de sécurisation, et peut notamment être utilisé au sein d'un terminal de paiement.

### 2. Art Antérieur

De nombreux dispositifs reposent sur la lecture d'une carte magnétique (également connue sous le nom de carte à bande magnétique) pour fournir un service ou délivrer une autorisation. La carte magnétique reste par exemple un moyen de paiement très répandu dans de nombreux pays, et les terminaux de paiement électroniques sont donc souvent équipés d'un lecteur de carte magnétique, utilisé pour lire les informations présentes sur la bande magnétique de la carte magnétique d'un client, et permettre ainsi de procéder au paiement. Un lecteur de carte magnétique comprend de manière classique une rainure destinée à guider le déplacement d'une carte magnétique dans le lecteur, ainsi qu'une tête de lecture magnétique associée à un circuit imprimé. Lorsque la carte est glissée dans la rainure du lecteur de bande magnétique (par exemple du haut vers le bas), la bande magnétique de la carte se déplace devant la tête de lecture. Cette bande magnétique mobile, qui contient des domaines magnétiques de polarité alternée, génère alors un champ magnétique dans l'ouverture de détection étroite (entrefer) de la tête de lecture. La tête de lecture convertit les variations de ce champ magnétique en un signal électrique. Le circuit imprimé associé à la tête de lecture comprend par exemple un circuit de décodage, qui amplifie et numérise le signal électrique, ce qui permet de recréer la même séquence de données que celle inscrite à l'origine sur la bande magnétique (par interprétation d'une succession d'intervalles long et courts). Les données de la carte magnétique sont ainsi obtenues, et elles peuvent alors être exploitées pour la mise en oeuvre d'un traitement approprié au sein du dispositif intégrant le lecteur de carte magnétique.

Une tête de lecture employée usuellement dans un lecteur de carte magnétique comprend par exemple un noyau en matériau ferromagnétique doux comprenant un entrefer étroit (l'entrefer formant l'ouverture de détection de la tête de lecture magnétique), et un bobinage enroulé autour de ce noyau. Lors du mouvement de translation de la carte magnétique dans la rainure du lecteur, une extrémité de la tête de lecture magnétique rentre en contact physique avec la bande magnétique de la carte magnétique. La carte magnétique exerce alors une pression sur la tête de lecture magnétique. La tête de lecture doit donc être capable de se déplacer perpendiculairement à l'axe de translation d'une carte dans la rainure. Pour permettre ce déplacement, une tête de lecture magnétique est généralement montée sur un dispositif de maintien, comme illustré par exemple dans la demande de brevet FR3037689. Dans une dénomination large, on désigne donc souvent sous le terme de « tête de lecture » l'ensemble comprenant la tête de lecture en elle-même, un dispositif de maintien (support de tête magnétique) sur lequel elle est fixée, et un circuit imprimé de raccordement au reste du dispositif, comprenant souvent une partie flexible. Le dispositif de maintien permet de stabiliser la tête de lecture magnétique lors de la lecture d'une carte et notamment de limiter le gîte de la tête de lecture qui peut être induit par le passage d'une carte magnétique dans le lecteur, tout en assurant un retour de la tête de lecture magnétique à sa position d'origine.

Un inconvénient des têtes de lectures actuellement utilisées dans les lecteurs de cartes magnétiques réside dans leur épaisseur. Bien que des progrès aient été réalisés en la matière, les têtes de lecture de ces lecteurs n'ont pas atteint le même degré de miniaturisation que la plupart des autres composants électroniques utilisés. Il en résulte que l'épaisseur de ces têtes de lectures - qui est de l'ordre de quelques millimètres, au minimum trois millimètres pour les têtes de lecture les plus fines employées dans les lecteurs actuels - constitue un facteur limitatif non négligeable lorsqu'il s'agit de concevoir des lecteurs de carte à mémoire à l'intégration poussée, plus compacts. Cette contrainte liée à l'épaisseur des têtes de lectures actuelles soulève également des problèmes de sécurité. En effet, une telle épaisseur offre des opportunités de fraudes aux personnes malveillantes : plus le lecteur de carte magnétique est épais, et plus les possibilités d'y installer un dispositif de lecture frauduleux permettant de récupérer discrètement les données d'une carte magnétique à l'insu de son propriétaire sont importantes.

Il existe donc un besoin de lecteurs de carte magnétique à la fois plus compacts et mieux sécurisés, et qui ne présentent pas au moins certains des inconvénients exposés précédemment.

Il est également connu de l'art antérieur des lecteurs de cartes magnétiques comprenant un assemblage à tête magnétique comme celui de la demande de brevet US2015097033 et des lecteurs comprenant des capteurs à magnétorésistance à effet tunnel TMR comme dans les demandes de brevet CN103576101 et JP2015200551.

### 3. Résumé

La technique proposée se rapporte à un lecteur de carte magnétique qui ne présente pas ces inconvénients de l'art antérieur. Un tel lecteur de carte magnétique est défini selon la revendication 1. Selon la technique proposée, la tête de lecture magnétique comprend un capteur à magnétorésistance à effet tunnel positionné dans un évidement d'une paroi latérale de ladite rainure. Le capteur, de façon optimisé, est positionné pour capter le champ magnétique dans la direction de passage de la carte. On notera que positionner le capteur de façon à capter un champ magnétique normal (perpendiculaire) à la piste présente des avantages sur la distance de lecture.

À des fins de simplification, le capteur à magnétorésistance à effet tunnel est désigné sous le terme plus concis de capteur magnétique TMR dans le reste du document (TMR étant le sigle usuel employé pour désigner la magnétorésistance à effet tunnel, par référence au terme anglais *« tunnel magnetoresistance »*).

De cette manière, on met en oeuvre un lecteur de carte magnétique plus compact que les lecteurs de carte magnétique de l'art antérieur grâce à l'utilisation d'un capteur magnétique TMR caractérisé par sa faible épaisseur, tout en protégeant ce capteur des chocs mécaniques en le positionnant au sein d'un évidement d'une paroi latérale de la rainure de déplacement d'une carte magnétique au sein du lecteur. Le lecteur de carte magnétique présente ainsi une sécurisation accrue, dans la mesure où l'espace exploitable par un fraudeur pour insérer une tête de lecture frauduleuse au sein de la rainure du capteur est considérablement réduit.

Selon une première implémentation du lecteur de carte magnétique, la paroi latérale prend la forme d'une paroi en matière plastique recouvrant au moins partiellement ledit premier circuit imprimé, ledit évidement étant un évidement traversant de ladite paroi latérale.

Ainsi, avec cette première implémentation, une première protection du capteur magnétique TMR est mise en oeuvre de manière très simple mais néanmoins efficace, par le recouvrement du premier circuit imprimé par une paroi latérale en matière plastique. L'évidement est alors traversant, ce qui permet de créer un logement au sein duquel la tête de lecture magnétique montée sur le premier circuit imprimé peut prendre place, et être protégée. L'évidement est notamment conçu de façon à ce qu'aucune « marche » ne vienne entraver le glissement de la carte. En effet, de telles marches sont susceptibles de créer des variations de vitesse de la carte magnétique lors de son déplacement dans la rainure, qui peuvent perturber le décodage des informations de la piste magnétique (par exemple, lors d'un ralentissement de la carte, un intervalle long est susceptible d'être interprété par un intervalle court).

Selon une caractéristique particulière de cette première implémentation, ladite paroi latérale est en matière plastique dissipative, ledit premier circuit imprimé comprend au moins une piste de décharge électrostatique en contact avec ladite paroi latérale.

De cette manière, les charges électrostatiques potentiellement générées par le mouvement de la carte magnétique dans la rainure sont évacuées, de façon douce, vers des zones peu sensibles à l'électricité statique du lecteur avant que la carte magnétique arrive en vis-à-vis du capteur magnétique TMR. On évite ainsi d'endommager ce capteur particulièrement sensible aux décharges électrostatiques.

Selon une deuxième implémentation du lecteur de carte magnétique, la paroi latérale est formée au moins partiellement par ledit premier circuit imprimé, ledit évidement étant un évidement borgne dudit premier circuit imprimé.

Ainsi, avec cette deuxième implémentation, il est possible d'obtenir un lecteur de carte magnétique encore plus compact, puisque le premier circuit imprimé fait lui même office d'une des paroi de la rainure de déplacement d'une carte magnétique. Le capteur magnétique TMR prend alors position au sein d'un évidement du premier circuit imprimé. De cette manière, la sécurisation globale du lecteur de carte magnétique contre l'installation de tête de lecture magnétique frauduleuse est encore accrue, puisque l'espace exploitable pour mettre en oeuvre une telle fraude est encore réduit.

Selon une caractéristique particulière de cette deuxième implémentation, ledit premier circuit imprimé comprend un élément de protection s'étendant sur une majeure partie du premier circuit imprimé, autour dudit évidemment.

Ainsi, on réduit encore l'espace exploitable pour l'installation d'une tête de lecture magnétique frauduleuse dans le lecteur. En effet, l'élément de protection permet de détecter toute tentative visant à creuser dans la surface du premier circuit imprimé pour y positionner une telle tête de lecture frauduleuse. L'élément de protection peut notamment se présenter sous la forme d'un treillis de protection intégré dans une couche interne du premier circuit imprimé, proche de la surface formant un des côtés de la rainure, s'étendant sur une majeure partie de cette surface, autour de l'évidement.

Selon une autre caractéristique particulière de cette deuxième implémentation, ledit premier circuit imprimé comprend au moins une piste de décharge électrostatique, autour dudit évidement.

Cette piste est disposée en surface du premier circuit imprimé, côté rainure. Ainsi les charges électrostatiques potentiellement générées par le mouvement de la carte magnétique dans la rainure sont évacuées vers des zones peu sensibles à l'électricité statique du lecteur avant que la carte magnétique arrive en vis-à-vis du capteur magnétique TMR. On évite ainsi d'endommager ce capteur particulièrement sensible aux décharges électrostatiques. En outre, ces pistes sont dimensionnées et conformées de manière à favoriser le glissement de la carte magnétique sur le premier circuit imprimé (qui forme selon le deuxième implémentation une des parois de la rainure), lors du déplacement de la carte magnétique dans la rainure.

Selon un mode de réalisation particulier, ledit premier circuit imprimé comprend au moins une piste de décharge électrostatique positionnée dans ledit évidemment, autour dudit capteur magnétique TMR.

De cette manière, les charges électrostatiques résiduelles qui n'auraient pas encore été évacuées par d'autres piste de décharge électrostatique potentiellement présentes en amont du capteur magnétique TMR sont dirigées vers des zones peu sensibles à l'électricité statique du lecteur avant que la carte magnétique arrive en vis-à-vis du capteur magnétique TMR. On évite ainsi d'endommager ce capteur particulièrement sensible aux décharges électrostatiques.

Selon un mode de réalisation particulier, ladite tête de lecture magnétique est constituée dudit capteur magnétique TMR.

De cette manière, la tête de lecture magnétique est réduite à un unique composant de faible épaisseur (de l'ordre du demi-millimètre), soudé sur le premier circuit imprimé. Ainsi, un lecteur de carte magnétique particulièrement compact et sécurisé est mis en oeuvre.

Selon l'invention, ladite tête de lecture magnétique comprend, outre ledit capteur magnétique TMR :
- un deuxième circuit imprimé, comprenant une portion de réception sur laquelle est monté ledit capteur magnétique TMR, et une portion de raccordement pour le raccordement électrique de ladite tête de lecture magnétique ;
- un dispositif de maintien, solidaire de ladite portion de réception, ledit dispositif de maintien comprenant des moyens de fixation pour la fixation mécanique de ladite tête de lecture magnétique.

De cette manière, la tête de lecture magnétique n'est plus réduite au seul capteur magnétique TMR, mais consiste en une tête de lecture magnétique au sens large du terme, qui comprend par ailleurs un deuxième circuit imprimé qui lui est propre permettant notamment son raccordement électrique au premier circuit imprimé, ainsi qu'un dispositif de maintien permettant notamment sa fixation mécanique au premier circuit imprimé (ou à un autre point du lecteur). En particulier, la portion de réception peut prendre la forme d'un circuit imprimé rigide de dimensions d'environ un centimètre par un centimètre, la portion de raccordement peut prendre la forme d'un circuit imprimé flexible, et le dispositif de maintien peut prendre la forme d'une lame métallique soudée à la portion de réception. De cette manière, la tête de lecture selon la technique proposée peut être conformée et dimensionnée pour que sa forme et ses dimensions correspondent à celles d'une tête de lecture classique. Une gestion appropriée du signal de sortie délivré par une telle tête de lecture magnétique permet alors de la rendre compatible avec le matériel existant. Une telle tête de lecture magnétique à capteur magnétique TMR peut par exemple être utilisée pour remplacer une tête de lecture magnétique classique défaillante au sein d'un terminal de paiement de génération plus ancienne.

Selon un mode de réalisation particulier, le lecteur de carte magnétique comprend en outre un élément de recouvrement dudit capteur magnétique TMR.

De cette manière, on complète la protection du capteur magnétique TMR déjà mise en oeuvre au moyen de l'évidement et des éventuelles pistes de décharges électrostatiques prévues par une protection additionnelle plus particulièrement centrée sur une protection de la partie supérieure du capteur magnétique TMR (c'est à dire la partie du capteur magnétique TMR qui se trouve en vis-à-vis d'une carte magnétique lors de sa lecture).

Selon une première caractéristique particulière de ce mode de réalisation, ledit élément de recouvrement est un film polyimide.

Ainsi on protège de manière simple et efficace le capteur magnétique TMR en utilisant un élément de recouvrement à la fois très fin, très résistant, et imperméable aux décharges électrostatiques. En outre, la mise en oeuvre de cet élément de recouvrement est très simple : le film polyimide est positionné de manière à recouvrir le capteur magnétique TMR, puis les bords de ce films sont par exemple collés sur le circuit imprimé sur lequel le capteur magnétique TMR est monté, dans une zone périphérique dudit capteur. A cet effet, le film polyimide peut notamment être revêtu d'un adhésif sur tout ou partie d'au moins une de ses surfaces.

Selon une deuxième caractéristique particulière de ce mode de réalisation, ledit élément de recouvrement prend la forme d'une capsule protectrice venant encapsuler ledit capteur magnétique TMR, ladite capsule prenant la forme d'un capot métallique, ou étant formée par injection de matière plastique, de résine, ou de céramique.

De cette manière, le capteur magnétique TMR est protégé de manière efficace en particulier contre les chocs mécanique, par la mise en oeuvre d'une capsule protectrice rigide et résistante. Dans le cas d'une capsule protectrice mise en oeuvre par injection de matière, l'intégrité structurelle de la tête de lecture peut également être renforcée, en injectant la matière de manière à intégrer d'autres éléments en plus du capteur magnétique TMR au sein de la capsule protectrice ainsi formée (par exemple, le deuxième circuit imprimé et une partie du dispositif de maintien, dans le cas d'une tête de lecture comprenant de tels éléments).

Dans une implémentation particulière, ladite capsule est chanfreinée.

Ainsi, la partie chanfreinée permet de guider et faciliter le glissement d'une carte magnétique qui vient au contact de la partie supérieure de la capsule protectrice lors de son déplacement dans la rainure du lecteur de carte magnétique. Ceci permet notamment d'éviter la présence de marches brusques, qui pourraient gêner le glissement de la carte.

Selon une troisième caractéristique particulière de ce mode de réalisation, ledit élément de recouvrement prend la forme d'un repli d'un circuit imprimé flexible sur ledit capteur magnétique TMR.

De cette manière, la protection notamment supérieure du capteur magnétique TMR peut être mise en oeuvre en oeuvre simplement, sans recourir à des éléments de protections spécifiques susceptibles d'entrainer une augmentation des coût de production et une complexification du procédé de fabrication du lecteur de carte magnétique. En particulier, le repli peut correspondre à un repli d'une partie flexible du premier ou du deuxième circuit imprimé.

Dans une implémentation particulière, ledit repli comprend au moins une piste de décharge électrostatique.

Ainsi les charges électrostatiques susceptibles d'endommager le capteur magnétique TMR peuvent être évacuées vers des zones peu sensibles à l'électricité statique du lecteur lors du déplacement d'une carte magnétique dans la rainure du lecteur de carte magnétique.

Les différents modes de réalisation mentionnés ci-dessus sont combinables entre eux.

### 4. Dessins

D'autres caractéristiques et avantages apparaîtront plus clairement à la lecture de la description suivante d'un mode de réalisation préférentiel, donné à titre de simple exemple illustratif et non limitatif, et des dessins annexés, parmi lesquels :
- la figure 1 présente une vue partielle et en coupe d'un lecteur de carte magnétique selon une première implémentation de la technique proposée ;
- la figure 2 présente une vue partielle et en coupe d'un lecteur de carte magnétique selon une deuxième implémentation de la technique proposée ;
- la figure 3 montre un premier exemple de tête de lecture magnétique au sens large du terme, dans un mode de réalisation particulier ;
- la figure 4 montre un deuxième exemple de tête de lecture magnétique au sens large du terme, dans un autre mode de réalisation particulier ;
- la figure 5 illustre un exemple de mise en oeuvre d'un lecteur de carte magnétique dans un autre mode de réalisation particulier ;
- la figure 6 présente schématiquement un terminal de paiement comprenant un lecteur de carte magnétique dans un mode de réalisation particulier de la technique proposée.

### 5. Description

### 5.1. Remarques préliminaires

Dans toute la description, les éléments de même nature sont identifiés par une même référence numérique dans les figures. Comme exposé précédemment, le terme « capteur magnétique TMR » est utilisé pour désigner un capteur à magnétorésistance à effet tunnel dans l'ensemble du présent document. Une rainure de déplacement d'une carte magnétique est formée par deux parois latérales et par un fond. A des fins de simplification, seule la paroi latérale intégrant le capteur magnétique TRM est représentée sur les figures. De même, toute référence à « la paroi latérale » dans le présent document doit être entendue comme une référence à la paroi latérale de la rainure qui intègre le capteur magnétique TRM. En outre, les termes « premier circuit imprimé » et « deuxième circuit imprimé » utilisés dans le présent document visent uniquement à permettre d'établir une distinction entre ces deux circuits imprimés, et n'impliquent aucunement l'existence d'une quelconque relation d'ordre entre ces circuits imprimés.

### 5.2. Principe général

Il est proposé un lecteur de carte magnétique qui comprend, de manière classique, une rainure de déplacement d'une carte magnétique, et une tête de lecture magnétique montée sur un premier circuit imprimé, de manière à permettre la lecture d'une bande magnétique de la carte magnétique. Le lecteur de carte magnétique selon la technique proposée se distingue cependant des lecteurs de carte magnétique connus en ce que la tête de lecture magnétique utilisée comprend un capteur à magnétorésistance à effet tunnel, également appelé capteur magnétique TMR.

Un capteur magnétique TMR est un capteur qui exploite la magnétorésistance à effet tunnel pour mesurer un champ magnétique. La magnétorésistance à effet tunnel (TMR) est une propriété qui apparaît au niveau d'une fine membrane isolante (de l'ordre de un à deux nanomètres d'épaisseur) - appelée jonction tunnel - qui sépare deux matériaux ferromagnétiques. Selon cette propriété, la résistance électrique opposée au passage du courant par effet tunnel d'un matériau ferromagnétique à l'autre au travers de la membrane isolante fluctue selon l'orientation relative des deux couches magnétiques formées par les matériaux ferromagnétiques. Cette propriété ne fait pas l'objet en tant que tel de la technique telle que proposée et n'est donc pas détaillée plus en avant dans le présent document. Les capteurs magnétiques TMR sont connus, mais les inventeurs ont constaté que leur grande fragilité mécanique et leur sensibilité importante aux décharges électrostatiques font qu'ils n'étaient pas possible jusqu'à présent de les utiliser dans des contextes rudes de type lecture de carte magnétique. A titre d'illustration, plusieurs centaines de milliers de passages de cartes peuvent être effectués pendant la durée de vie d'un lecteur de carte magnétique d'un terminal de paiement. Un tel lecteur est donc soumis à de fortes contraintes mécaniques. En outre, le mouvement de la carte dans le lecteur est source de décharges électrostatiques fréquentes au sein du terminal. On comprend dès lors les contraintes techniques à utiliser de tels capteurs magnétiques TRM au sein d'un lecteur de carte magnétique. De tels capteurs ont pourtant l'avantage d'être de très faible épaisseur par rapport aux têtes de lecture magnétique classiquement utilisés dans les lecteurs de carte magnétique. Certains capteurs magnétiques TMR présentent ainsi une épaisseur inférieure au demi-millimètre, contre des épaisseurs de plusieurs millimètres au mieux pour les têtes de lecture magnétique classiques (épaisseur de l'ordre de trois millimètres environ, pour les têtes de lecture magnétique les plus fines utilisées actuellement au sein de lecteurs de carte magnétique). Les capteurs magnétiques TMR présente également l'avantage d'être moins sensibles à la distance (par rapport au champ magnétique à mesurer) qu'une tête de lecture magnétique classique (i.e. un capteur magnétique TMR n'a pas besoin d'être aussi « proche » du champ magnétique à mesurer qu'un tête de lecture magnétique classique).

On propose donc des solutions visant à surmonter les contraintes précitées, en décrivant des moyens de mise en oeuvre d'un lecteur de carte magnétique qui repose sur l'utilisation d'un capteur magnétique TMR comme tête de lecture magnétique pour la lecture d'une carte magnétique. Selon le principe général de la technique proposée, un tel capteur magnétique TMR est positionné dans un évidement d'une paroi latérale de la rainure de déplacement de la carte magnétique. Ainsi, il est possible de mettre en oeuvre de lecteurs de carte magnétique plus compacts que ceux de l'art antérieur et, de manière incidente, mieux sécurisés (pour les raisons exposées notamment en relation avec l'art antérieur). Les côtés de l'évidement offre une première protection, notamment latérale, du capteur magnétique TMR. Diverses implémentations sont proposées, afin de protéger de manière astucieuse le capteur magnétique TMR, tant contre les chocs et usures mécaniques que contre les décharges électrostatiques qui peuvent survenir lors du passage d'une carte magnétique dans la rainure du lecteur.

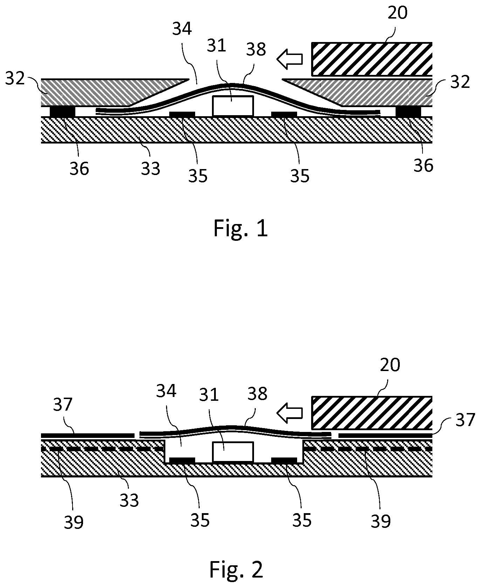

Dans une première implémentation d'un lecteur de carte magnétique, illustrée en relation avec la **figure 1****,** la paroi latérale prend la forme d'une paroi en matière plastique 32 qui vient recouvrir au moins partiellement le premier circuit imprimé 33, sur lequel est monté la tête de lecture magnétique 31. Le capteur magnétique TMR 31 prend alors place dans un évidement 34 traversant de la paroi latérale 32. L'évidement 34 peut notamment prendre la forme d'un cône, avec une base plus élargie du côté du premier circuit imprimé 33. Ainsi, on libère de la place sur le premier circuit imprimé 33 pour installer des composants auprès du capteur magnétique TMR 31, tout en permettant une protection optimale du capteur magnétique TMR. De cette manière, la paroi latérale 32 forme un capotage en matière plastique, qui favorise notamment le glissement d'une carte magnétique 20 lors de son déplacement dans la rainure. Dans différents modes de réalisation, des pistes électriques sont prévues sur le premier circuit imprimé 33, pour protéger le capteur magnétique TMR 31 contre l'électricité statique générée notamment lors du passage d'une carte dans le lecteur. De telles pistes électriques font office de « drains » de masse, permettant d'évacuer les charges électrostatiques vers des zones peu sensibles du lecteur, évitant ainsi d'endommager le capteur magnétique TMR. Dans un mode de réalisation particulier, des pistes de décharge électrostatique 35 sont ainsi positionnées autour du capteur magnétique TMR, dans l'évidement 34. Ces pistes peuvent notamment être disposées de part et d'autre du capteur, dans l'axe de déplacement de la carte magnétique au sein de la rainure, de manière à assurer qu'une telle piste soit toujours présente en amont du capteur magnétique TMR quelque soit le sens de déplacement de la carte dans la rainure. De manière alternative ou complémentaire, dans un autre mode de réalisation particulier, la paroi latérale 32 est formée dans une matière plastique dissipative, et des pistes de décharge électrostatique 35 présentes sur le premier circuit imprimé 33 sont positionnées hors de l'évidement 34, de manière à être, au niveau de zones dites de reprises de contact, en contact avec la paroi latérale 32, là encore pour favoriser l'évacuation des charges électrostatiques.

Dans une deuxième implémentation, illustré en relation avec la **figure 2****,** la paroi latérale est formée au moins partiellement par le premier circuit imprimé 33. Dans ce cas, l'évidement 34 au sein duquel est positionné le capteur magnétique TMR est un évidement borgne aménagé dans le premier circuit imprimé 33, c'est à dire un évidement non traversant. Dans un mode de réalisation particulier, le premier circuit imprimé 33 comprend en outre un élément de protection 39 qui s'étend sur une majeure partie du premier circuit imprimé 33, autour de l'évidement 34. Avantageusement, cet élément de protection 39 prend la forme d'un treillis de protection s'étendant dans une couche interne du premier circuit imprimé 33, proche de la rainure. Un tel élément de protection permet notamment la détection de toute tentative de fraude qui consisterait à creuser le premier circuit imprimé 33 pour y insérer une tête de lecture magnétique frauduleuse, et la mise en oeuvre de mesures de protection appropriées (alarme, mise hors service du lecteur de carte magnétique, etc.). Le fait que le capteur magnétique TMR soit inséré dans un tel borgne du premier circuit imprimé (i.e. dans une cavité du premier circuit imprimé) permet notamment de placer un tel treillis de protection au plus près de la rainure du lecteur de carte à magnétique, c'est à dire au plus près de la zone de déplacement de la carte magnétique, et donc de limiter considérablement l'épaisseur disponible pour placer une tête magnétique frauduleuse dans le lecteur.

Dans un mode de réalisation particulier, la surface du premier circuit imprimé 33 comprend, côté rainure et autour de l'évidement 34, au moins une piste de décharge électrostatique 37. Ces pistes 37 permettent de décharger électriquement une carte magnétique 20 lors de son déplacement dans la rainure, avant qu'elle ne se trouve en vis-à-vis du capteur magnétique TMR 31. Ces pistes peuvent notamment prendre la forme d'un plan de masse présentant une très bonne résistance à l'usure, favorisant également ainsi le glissement de la carte 20 directement sur le premier circuit imprimé, dans la rainure. Comme dans la première implémentation, des pistes de décharge électrostatique 35 peuvent également être disposées, de manière alternative ou complémentaire, dans l'évidement même, autour du capteur magnétique TRM 31, par exemple de part et d'autre de ce capteur dans l'axe de déplacement de la carte magnétique au sein de la rainure.

Les deux implémentations présentées en relation avec les figures 1 et 2 présentent l'avantage, vis-à-vis des lecteurs de carte magnétique de l'art antérieur, de compliquer de manière importante l'installation d'une tête de lecture magnétique frauduleuse au sein du lecteur. En effet, la hauteur de l'évidement est sensiblement égale à l'épaisseur d'un capteur magnétique TMR, qui est, pour les capteurs les plus fins, de l'ordre du demi-millimètre. Une personne malveillante ne disposera donc que de cette très faible épaisseur pour tenter d'y installer une tête de lecture frauduleuse et les composants nécessaires à son raccordement à un dispositif d'enregistrement. L'installation d'un élément de protection (par exemple un treillis) au sein de la paroi permet en outre de limiter encore l'espace disponible pour mettre en oeuvre une telle fraude, en réduisant l'épaisseur exploitable par une personne malveillante à deux ou trois dixièmes de millimètres. On comprend dès lors qu'un lecteur de carte magnétique selon la technique proposée est plus sécurisé que les lecteurs de carte magnétique de l'art antérieur qui intègrent une tête de lecture magnétique classique de plusieurs millimètres d'épaisseur.

On présente maintenant différents modes de réalisation particuliers d'un lecteur de carte magnétique selon la technique proposée, qui peuvent être mis en oeuvre indifféremment dans le cadre de l'une ou l'autre des deux implémentations précédemment décrites. Ces modes de réalisation additionnels se rapportent pour certains à la structure même de la tête de lecture magnétique utilisée dans le lecteur de carte magnétique, et pour d'autres à différentes manière de mettre en oeuvre une protection complémentaire du capteur magnétique TMR de la tête de lecture magnétique, au moyen d'un élément de recouvrement.

### 5.3. Nature de la tête de lecture magnétique

Dans un mode de réalisation particulier, la tête de lecture magnétique du lecteur de carte magnétique est constituée uniquement du capteur magnétique TMR (comme cela est notamment illustré dans les exemples des figures 1 et 2, où le capteur magnétique TMR 31 est directement soudé sur le premier circuit imprimé et forme la tête de lecture magnétique.

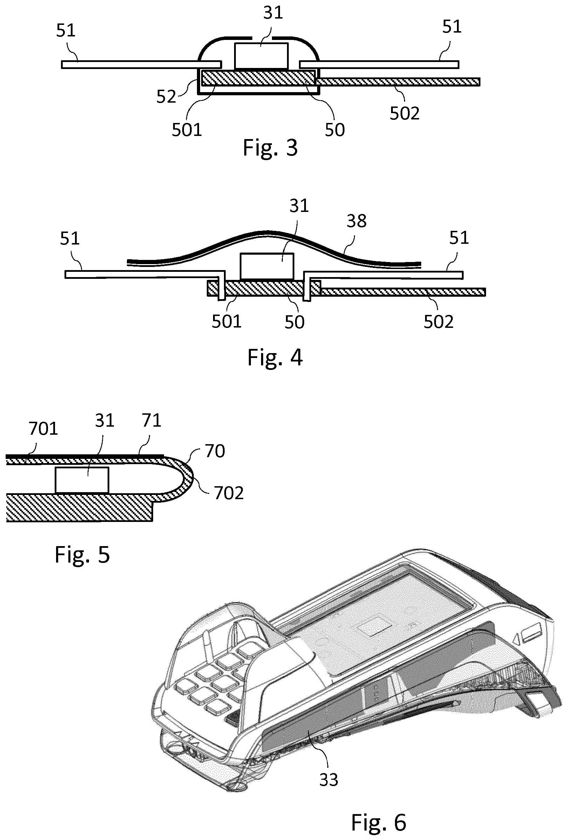

Cependant, dans un autre mode de réalisation particulier, dont des exemples sont illustrés en relation avec les **figures 3 et 4****,** une tête de lecture magnétique *« classique »* est construite à partir d'un composant TMR. Plus particulièrement, la tête de lecture magnétique comprend, outre le capteur magnétique TMR 31, son propre circuit imprimé 50 (appelé « deuxième » circuit imprimé dans le présent document, à des fins de différenciation avec le « premier » circuit imprimé défini précédemment, qui est le circuit imprimé sur lequel est monté la tête de lecture magnétique) ainsi qu'un dispositif de maintien 51. Le deuxième circuit imprimé 50 comprend une portion de réception 501 sur laquelle est monté le capteur magnétique TMR 31, et une portion de raccordement 502 pour le raccordement électrique de la tête de lecture magnétique. Le dispositif de maintien 51 est solidaire de la portion de réception 501, et il comprend des moyens de fixation et un système de ressort, pour la fixation mécanique de la tête de lecture magnétique.

En particulier, la portion de réception 501 peut prendre la forme d'un circuit imprimé rigide se présentant sous la forme d'une plaque sensiblement carrée d'environ un centimètre de coté, et la portion de raccordement 502 peut prendre la forme d'un circuit imprimé flexible permettant par exemple le raccordement électrique du deuxième circuit imprimé 50 au premier circuit imprimé. Le dispositif de maintien 51 peut prendre la forme d'une lame métallique soudée à la portion de réception 501. Ainsi, la tête de lecture TMR peut être conformée et dimensionnée pour que sa forme et ses dimensions correspondent à celles d'une tête de lecture classique. En particulier, le dispositif de maintien 51 peut revêtir une forme similaire à un dispositif de maintien existant. On dispose ainsi d'une tête de lecture magnétique de nouvelle génération - car exploitant la magnétorésistance à effet tunnel pour mesurer le champ magnétique - mais qui reste compatible avec le matériel existant conçu à l'origine pour accueillir des têtes de lecture classiques (sous réserve bien sûr d'une gestion appropriée du signal de sortie délivré par une telle tête de lecture magnétique). Plus particulièrement, la lame métallique 51 est alors conformée et dimensionnée de manière d'une part à permettre la fixation de la tête de lecture magnétique TRM sur un emplacement de tête de lecture classique, et d'autre part à maintenir le capteur magnétique TMR 31 à une hauteur permettant de limiter l'espace entre le capteur et la bande magnétique d'une carte magnétique lorsqu'une telle carte est déplacée dans la rainure du lecteur, de manière à en permettre la lecture.

La soudure de la lame métallique 51 sur la portion de réception 501 du deuxième circuit imprimé 50 peut être réalisée par des moyens traditionnels de soudure de composants montés en surface (CMS), par exemple en refusion, comme illustré en figure 3. Alternativement, la lame métallique comprend des plis destinés à être insérés dans des trous métallisés traversants complémentaires de la portion de réception 501, puis soudés (cette alternative, illustrée sur la figure 4, permet notamment afin de conférer plus de robustesse à la tête de lecture magnétique).

Dans l'exemple de la figure 3, en outre, la tête de lecture comprend une enveloppe, par exemple une capsule 52 métallique ou en matière plastique rigide, permettant d'unifier l'ensemble des composants (circuit imprimé, capteur magnétique TMR et lame métallique) dans un seul et même composant pouvant être utilisé en replacement de composants existants.

Ces modes de réalisation selon lesquels la tête de lecture magnétique comprend son propre circuit imprimé (le deuxième circuit imprimé 50) sont également intéressants dans la mesure où ils permettent de mettre en oeuvre une tête de lecture magnétique sécurisée par nature : en effet, des éléments de protection de type treillis peuvent être intégrés directement dans des couches externes des portions de réception 501 et de raccordement 502, de manière à sécuriser les signaux transitant dans la tête de lecture magnétique (la sécurisation portant alors aussi bien sur les signaux véhiculant des données que sur les signaux permettant d'alimenter électriquement la tête). Bien que cela ne soit pas représenté sur les figures, les têtes de lecture magnétique au sens large telles que décrites en relation avec les figures 3 et 4 sont bien entendus compatibles avec les implémentations décrites en relation avec les figures 1 et 2, et elles peuvent à ce titre être positionnées dans un évidement d'une paroi latérale de la rainure de déplacement d'une carte magnétique.

### 5.4. Élément de recouvrement

Dans une implémentation particulière, le lecteur de carte magnétique comprend un élément de recouvrement du capteur magnétique TMR. Cet élément de recouvrement est destiné à venir protéger le capteur magnétique TMR, notamment dans sa partie supérieure. La protection est mécanique et/ou électrique. Divers modes de réalisation d'un tel élément de recouvrement sont présentés ci-après.

Dans un premier mode de réalisation particulier, l'élément de recouvrement est un film polyimide qui vient recouvrir intégralement le capteur magnétique TMR. Dans les exemples illustrés en figures 1 et 2 dans lesquels la tête de lecture magnétique est constituée uniquement du capteur magnétique TMR 31 directement soudé sur le premier circuit imprimé 33, un tel film polyimide 38 est collé sur sa périphérie sur le premier circuit imprimé 33. Dans l'exemple illustré en figure 4, dans lequel la tête de lecture magnétique se présente sous la forme intégrée d'une tête de lecture magnétique classique comprenant, outre le capteur magnétique TMR 31, son propre circuit imprimé 50 et un dispositif de maintien 51, le film polyimide 38 est par exemple collé dans sa périphérie sur le dispositif de maintien 51. Un tel film polyimide présente de nombreuses propriétés avantageuses. D'une part, il peut être très fin (par exemple d'une épaisseur de l'ordre de 50 micromètres) tout en étant très résistant non seulement aux sollicitations mécaniques mais également aux conditions climatiques et chimiques. Ainsi, il ne sera notamment pas facile à décoller une fois en place. D'autre part, le polyimide est une matière imperméable à la décharge électrostatique. Un tel film polyimide est donc un élément de protection particulièrement approprié pour protéger électriquement un capteur magnétique TMR, connu pour être un composant particulièrement sensible aux décharges électrostatiques. Le chemin dans l'air d'une telle protection sera d'autant plus grand que le recouvrement sera important, augmentant encore l'efficacité d'une telle protection. Selon une caractéristique particulière, les pistes de décharge électrostatique 35 déjà présentées en relation avec les figures 1 et 2 peuvent également être recouvertes par le film polyimide 38, de manière à empêcher une éventuelle charge électrostatique résiduelle de s'écouler vers le capteur magnétique TMR 31.

Dans un deuxième mode de réalisation particulier, dont un exemple est présenté en relation avec la figure 3 déjà décrite, l'élément de recouvrement prend la forme d'une capsule protectrice rigide 52 venant encapsuler le capteur magnétique TMR 31. La capsule protectrice 52 est par exemple un capot métallique prenant appui sur le circuit imprimé sur lequel le capteur magnétique TMR est soudé, et recouvrant ce capteur. La capsule protectrice 52 peut également être formée par une injection de matière plastique, de résine (résine époxy par exemple) ou de céramique autour du capteur magnétique TMR (la capsule protectrice peut alors éventuellement également encapsuler une partie du circuit imprimé sur lequel est soudé le capteur magnétique TMR). Selon une caractéristique particulière, et comme cela est visible sur la figure 3, la capsule protectrice 52 est notamment chanfreinée afin de guider et faciliter le glissement d'une carte magnétique qui viendrait au contact de la partie supérieure de la capsule protectrice lors de son déplacement dans la rainure du lecteur de carte magnétique. Par ailleurs, une telle capsule offre également l'avantage d'être résistante aux frottements des différentes cartes magnétiques : cette capsule permet ainsi de disposer d'une longévité accrue. Bien qu'illustrée seulement en relation avec la figure 3, une telle capsule protectrice peut bien entendu être mise en oeuvre pour protéger une tête de lecture constituée uniquement par un capteur magnétique TMR directement soudé sur le premier circuit imprimé, comme représenté en figure 1 ou 2.

Dans un troisième mode de réalisation particulier, illustré en relation avec la figure 5, l'élément de recouvrement prend la forme d'un repli 701 d'un circuit imprimé flexible 70 sur le capteur magnétique TMR 31. En particulier, ce repli peut être formé par un repli d'une partie flexible du premier circuit imprimé (le premier circuit imprimé 33 des figures 3 et 4, lorsque la tête de lecture magnétique est constitué d'un capteur magnétique TMR seul), ou du deuxième circuit imprimé (le deuxième circuit imprimé 50 des figures 5 et 6, lorsque la tête de lecture magnétique TRM est mise en oeuvre dans sa forme large, incluant un dispositif de maintien et un circuit imprimé qui lui est propre, afin d'être conformée et dimensionnée comme une tête de lecture magnétique classique de l'art antérieur). Pour limiter les contraintes mécaniques exercées par les passages répétés de cartes magnétiques dans la rainure sur le pli 702 permettant de former le repli 701, ce pli 702 est préférentiellement réalisé de manière à être parallèle à la direction de déplacement de la carte magnétique dans la rainure. Ceci permet également de limiter les effets de « chocs » qui pourraient conduire à un déplacement indésirable du circuit imprimé équipé du capteur magnétique TMR dans le sens de glissement de la carte magnétique, un tel déplacement étant susceptible de compromettre le décodage correct des informations de la piste magnétique de la carte. La mise en oeuvre de l'élément de recouvrement sous la forme d'un repli d'un circuit imprimé est avantageuse dans la mesure où elle permet, selon une caractéristique particulière, d'intégrer directement des pistes de décharge électrostatique 71 sur le repli, comme illustré sur la figure 5. Comme déjà décrit précédemment, ces pistes font office de « drains » de masse qui permettent d'évacuer les charges électrostatiques susceptibles d'endommager le capteur magnétique TMR vers des zones moins sensibles aux décharges électrostatiques.

Dans certains modes de réalisation, il est également envisagé de combiner plusieurs éléments de recouvrement (par exemple positionner un film polyimide au dessus d'une capsule protectrice) afin de bénéficier simultanément des avantages propres à chaque élément de recouvrement utilisé (par exemple, pour cumuler la résistance mécanique d'une capsule protectrice et l'imperméabilité aux décharges électrostatiques d'un film polyimide).

Le lecteur de carte magnétique selon la technique proposée peut avantageusement, dans ses différents modes de réalisation précédemment décrits, être mis en oeuvre au sein d'un terminal de paiement, comme illustré schématiquement en relation avec la figure 6. En particulier, le premier circuit imprimé 33, sur lequel est montée la tête de lecture magnétique, peut s'étendre sur la majeure partie d'une des parois latérales de la rainure de déplacement d'une carte magnétique. La mise en oeuvre conjointe d'un tel circuit imprimé, comprenant un treillis de protection qui s'étend alors sur la majeure partie de la rainure de déplacement, avec une tête de lecture magnétique comprenant un capteur magnétique TMR permet ainsi une intégration poussée du lecteur de carte magnétique au sein du terminal de paiement, offrant une solution à la fois mieux sécurisée et plus compacte que les solutions de l'art antérieur.

Bien que les différents modes de réalisation présentés dans la présente description et les dessins l'accompagnant décrivent, à titre illustratif, un lecteur de carte magnétique comprenant un seul capteur magnétique TMR, il est bien entendu possible, sans sortir du cadre de la technique proposée, d'utiliser conjointement plusieurs capteurs magnétiques TMR au sein d'un même lecteur de carte magnétique, afin par exemple de capter les différents champs magnétiques générés par les différentes pistes d'une carte magnétique multipistes.

## Revendications

1. Lecteur de carte magnétique comprenant une rainure de déplacement d'une carte magnétique et une tête de lecture magnétique montée sur un premier circuit imprimé (33), de manière à permettre la lecture d'une bande magnétique de la carte magnétique, ledit lecteur de carte magnétique étant **caractérisé en ce que** ladite tête de lecture magnétique comprend :
- un capteur à magnétorésistance à effet tunnel (31), appelé capteur magnétique TMR, positionné dans un évidemment (34) d'une paroi latérale de ladite rainure ;
- un deuxième circuit imprimé (50), comprenant une portion de réception (501) sur laquelle est monté ledit capteur magnétique TMR (31), et une portion de raccordement (502) pour le raccordement électrique de ladite tête de lecture magnétique ;
- un dispositif de maintien (51), solidaire de ladite portion de réception (501), ledit dispositif de maintien comprenant des moyens de fixation pour la fixation mécanique de ladite tête de lecture magnétique.

2. Lecteur de carte magnétique selon la revendication 1 **caractérisé en ce que** ladite paroi latérale prend la forme d'une paroi en matière plastique (32) recouvrant au moins partiellement ledit premier circuit imprimé (33), ledit évidement (34) étant un évidement traversant de ladite paroi latérale.

3. Lecteur de carte magnétique selon la revendication 2 **caractérisé en ce que** ladite paroi latérale (32) est en matière plastique dissipative, et **en ce que** ledit premier circuit imprimé (33) comprend au moins une piste de décharge électrostatique (36) en contact avec ladite paroi latérale (32).

4. Lecteur de carte magnétique selon la revendication 1 **caractérisé en ce que** ladite paroi latérale est formée au moins partiellement par ledit premier circuit imprimé (33), ledit évidement (34) étant un évidement borgne dudit premier circuit imprimé.

5. Lecteur de carte magnétique selon la revendication 4 **caractérisé en ce que** ledit premier circuit imprimé (33) comprend un élément de protection (39) s'étendant sur une majeure partie du premier circuit imprimé, autour dudit évidemment (34).

6. Lecteur de carte magnétique selon l'une quelconque des revendications 4 ou 5 **caractérisé en ce que** ledit premier circuit imprimé (33) comprend au moins une piste de décharge électrostatique (37), autour dudit évidement.

7. Lecteur de carte magnétique selon l'une quelconque des revendications précédentes **caractérisé en ce que** ledit premier circuit imprimé (33) comprend au moins une piste de décharge électrostatique (35) positionnée dans ledit évidemment (34), autour dudit capteur magnétique TMR (31).

8. Lecteur de carte magnétique selon l'une quelconque des revendications précédentes, **caractérisé en ce qu'**il comprend en outre un élément de recouvrement (38, 52, 701) dudit capteur magnétique TMR (31).

9. Lecteur de carte magnétique selon la revendication 8 **caractérisé en ce que** ledit élément de recouvrement est un film polyimide (38).

10. Lecteur de carte magnétique selon la revendication 8 **caractérisé en ce que** ledit élément de recouvrement prend la forme d'une capsule protectrice (52) venant encapsuler ledit capteur magnétique TMR, ladite capsule prenant la forme d'un capot métallique, ou étant formée par injection de matière plastique, de résine, ou de céramique.

11. Lecteur de carte magnétique selon la revendication 10 **caractérisé en ce que** ladite capsule (52) est chanfreinée.

12. Lecteur de carte magnétique selon la revendication 8 **caractérisé en ce que** ledit élément de recouvrement prend la forme d'un repli (701) d'un circuit imprimé flexible (70) sur ledit capteur magnétique TMR (31).

13. Lecteur de carte magnétique selon la revendication 12 **caractérisé en ce que** ledit repli (701) comprend au moins une piste de décharge électrostatique (71).

## Patentansprüche

1. Magnetkartenleser mit einer Rille zum Bewegen einer Magnetkarte und einem magnetischen Lesekopf, der auf einer ersten gedruckten Schaltung (33) montiert ist, um das Lesen eines Magnetstreifens der Magnetkarte zu ermöglichen, wobei der Magnetkartenleser **dadurch gekennzeichnet ist, dass** der magnetische Lesekopf Folgendes aufweist:
- einen Tunnel-magnetoresistiven Sensor (31), der als TMR-Magnetsensor bezeichnet wird und in einer Aussparung (34) einer Seitenwand der Rille positioniert ist;
- eine zweite gedruckte Schaltung (50), die einen Aufnahmeabschnitt (501), auf dem der TMR-Magnetsensor (31) montiert ist, und einen Anschlussabschnitt (502) für den elektrischen Anschluss des magnetischen Lesekopfes aufweist;
- eine Haltevorrichtung (51), die mit dem Aufnahmeabschnitt (501) fest verbunden ist, wobei die Haltevorrichtung Befestigungsmittel für die mechanische Befestigung des magnetischen Lesekopfes aufweist.

2. Magnetkartenleser nach Anspruch 1, **dadurch gekennzeichnet, dass** die Seitenwand die Form einer Kunststoffwand (32) annimmt, die die erste Leiterplatte (33) zumindest teilweise bedeckt, wobei die Aussparung (34) eine durchgehende Aussparung in der Seitenwand ist.

3. Magnetkartenleser nach Anspruch 2, **dadurch gekennzeichnet, dass** die Seitenwand (32) aus einem dissipativen Kunststoffmaterial besteht, und dass die erste gedruckte Schaltung (33) mindestens eine elektrostatische Entladungsbahn (36) aufweist, die mit der Seitenwand (32) in Kontakt steht.

4. Magnetkartenleser nach Anspruch 1, **dadurch gekennzeichnet, dass** die Seitenwand zumindest teilweise durch die erste gedruckte Schaltung (33) gebildet wird, wobei die Aussparung (34) eine Blindaussparung der ersten gedruckten Schaltung ist.

5. Magnetkartenleser nach Anspruch 4, **dadurch gekennzeichnet, dass** die erste gedruckte Schaltung (33) ein Schutzelement (39) aufweist, das sich über einen Großteil der ersten gedruckten Schaltung um die Aussparung (34) herum erstreckt.

6. Magnetkartenleser nach einem der Ansprüche 4 oder 5, **dadurch gekennzeichnet, dass** die erste gedruckte Schaltung (33) mindestens eine elektrostatische Entladungsspur (37), um die Aussparung herum, aufweist.

7. Magnetkartenleser nach einem der vorhergehenden Ansprüche, **dadurch gekennzeichnet, dass** die erste gedruckte Schaltung (33) mindestens eine elektrostatische Entladungsspur (35) aufweist, die in der Aussparung (34) um den TMR-Magnetsensor (31) herum positioniert ist.

8. Magnetkartenleser nach einem der vorhergehenden Ansprüche, **dadurch gekennzeichnet, dass** er ferner ein Abdeckelement (38, 52, 701) für den TMR-Magnetsensor (31) aufweist.

9. Magnetkartenleser nach Anspruch 8, **dadurch gekennzeichnet, dass** das Abdeckelement ein Polyimidfilm (38) ist.

10. Magnetkartenleser nach Anspruch 8, **dadurch gekennzeichnet, dass** das Abdeckelement die Form einer Schutzkapsel (52) annimmt, die den TMR-Magnetsensor einkapselt, wobei die Kapsel die Form einer Metallkappe annimmt oder durch Einspritzen von Kunststoff, Harz oder Keramik gebildet wird.

11. Magnetkartenleser nach Anspruch 10, **dadurch gekennzeichnet, dass** die Kapsel (52) abgeschrägt ist.

12. Magnetkartenleser nach Anspruch 8, **dadurch gekennzeichnet, dass** das Abdeckelement die Form einer Falte (701) einer flexiblen gedruckten Schaltung (70) auf dem TMR-Magnetsensor (31) annimmt.

13. Magnetkartenleser nach Anspruch 12, **dadurch gekennzeichnet, dass** die Falte (701) mindestens eine elektrostatische Entladungsspur (71) aufweist.

## Claims

1. Magnetic card reader comprising a groove in which a magnetic card is moved and a magnetic read head mounted on a first printed circuit (33), so as to read a magnetic stripe of the magnetic card, said magnetic card reader being **characterised in that** said magnetic read head comprises:
- a tunnel magnetoresistance (TMR) sensor (31) positioned in a recess (34) of a side wall of said groove;
- a second printed circuit (50), comprising a receiving portion (501) on which said tunnel magnetoresistance (TMR) sensor (31) is mounted, and a connection portion (502) for electrically connecting said magnetic read head;
- a holding device (51), attached to said receiving portion (501), said holding device comprising attachment means for mechanically attaching said magnetic read head.

2. Magnetic card reader according to claim 1, **characterised in that** said side wall consists of a wall made of plastic material (32) covering at least partially said first printed circuit (33), said recess (34) being a through recess of said side wall.

3. Magnetic card reader according to claim 2, **characterised in that** said side wall (32) is made of dissipative plastic material and **in that** said first printed circuit (33) comprises at least one electrostatic discharge track (36) in contact with said side wall (32).

4. Magnetic card reader according to claim 1, **characterised in that** said side wall consists at least partially of said first printed circuit (33), said recess (34) being a blind recess of said first printed circuit.

5. Magnetic card reader according to claim 4, **characterised in that** said first printed circuit (33) comprises a protection element (39) extending over a major part of the first printed circuit, around said recess (34).

6. Magnetic card reader according to claim 4 or 5, **characterised in that** said first printed circuit (33) comprises at least one electrostatic discharge track (37), around said recess.

7. Magnetic card reader according to any one of the preceding claims, **characterised in that** said first printed circuit (33) comprises at least one electrostatic discharge track (35) positioned in said recess (34), around said tunnel magnetoresistance (TMR) sensor (31).

8. Magnetic card reader according to any one of the preceding claims, **characterised in that** it further comprises a covering element (38, 52, 701) for covering said tunnel magnetoresistance (TMR) sensor (31).

9. Magnetic card reader according to claim 8, **characterised in that** said covering element is a polyimide film (38).

10. Magnetic card reader according to claim 8, **characterised in that** said covering element consists of a protective capsule (52) encapsulating said tunnel magnetoresistance (TMR) sensor, said capsule consisting of a metal cover, or being formed by injecting plastic material, resin or ceramic.

11. Magnetic card reader according to claim 10, **characterised in that** said capsule (52) is chamfered.

12. Magnetic card reader according to claim 8, **characterised in that** said covering element consists of a fold (701) of a flexible printed circuit (70) over said tunnel magnetoresistance (TMR) sensor (31).

13. Magnetic card reader according to claim 12, **characterised in that** said fold (701) comprises at least one electrostatic discharge track (71).
